# EUROPEAN PATENT SPECIFICATION

(11) **EP 3 499 281 B1**
(45) Date of publication and mention of the grant of the patent: **23.09.2020**
(21) Application number: 17206991.6
(22) Date of filing: 13.12.2017
(51) Int. Cl.: G02B 6/13, G01N 21/77

(54) **A METHOD FOR MANUFACTURING OF A PHOTONIC CIRCUIT**
VERFAHREN ZUR HERSTELLUNG EINER PHOTONISCHEN SCHALTUNG
PROCÉDÉ DE FABRICATION D'UN CIRCUIT PHOTONIQUE

(43) Date of publication of application: 19.06.2019
(73) Proprietor: IMEC vzw, 3001 Leuven (BE)
(72) Inventor: NEUTENS, Pieter, 3001 Leuven (BE)
(74) Representative: AWA Sweden AB

(56) References cited:
- EP-A1- 2 648 025
- US-A- 5 620 496
- CIRINO GIUSEPPE A ET AL: "Simulation and fabrication of silicon nitride microring resonator by DUV lithography", 2016 31ST SYMPOSIUM ON MICROELECTRONICS TECHNOLOGY AND DEVICES (SBMICRO), IEEE, 29 August 2016 (2016-08-29), pages 1-4, XP032992899, DOI: 10.1109/SBMICRO.2016.7731346 [retrieved on 2016-11-02]
- A. GORIN ET AL: "Fabrication of silicon nitride waveguides for visible-light using PECVD: a study of the effect of plasma frequency on optical properties", OPTICS EXPRESS, vol. 16, no. 18, 18 August 2008 (2008-08-18), page 13509, XP055486941, ISSN: 2161-2072, DOI: 10.1364/OE.16.013509
- SEPÚLVEDA B ET AL: "Optical biosensor microsystems based on the integration of highly sensitive Mach-Zehnder interferometer devices", JOURNAL OF OPTICS. A, PURE AND APPLIED OPTICS, INSTITUTE OF PHYSICS PUBLISHING, BRISTOL, GB, vol. 8, no. 7, 12 June 2006 (2006-06-12), pages S561-S566, XP020108527, ISSN: 1464-4258, DOI: 10.1088/1464-4258/8/7/S41
- SUBRAMANIAN A Z ET AL: "Low-Loss Singlemode PECVD Silicon Nitride Photonic Wire Waveguides for 532-900 nm Wavelength Window Fabricated Within a CMOS Pilot", IEEE PHOTONICS JOURNAL, IEEE, USA, vol. 5, no. 6, 1 December 2013 (2013-12-01), page 2202809, XP011533011, DOI: 10.1109/JPHOT.2013.2292698 [retrieved on 2013-12-03]
- D. T. KRICK ET AL: "Electrically active point defects in amorphous silicon nitride: An illumination and charge injection study", JOURNAL OF APPLIED PHYSICS, vol. 64, no. 7, 1 October 1988 (1988-10-01), pages 3558-3563, XP055486688, US ISSN: 0021-8979, DOI: 10.1063/1.341499

## Description

### Technical field

The present inventive concept relates to a method for manufacturing of a photonic circuit, wherein the photonic circuit comprises a silicon nitride light waveguide.

### Background

In the last decade, silicon nitride (SiN) has become the waveguide material of choice for visible wavelength photonic circuits, especially for on-chip integrated biosensors. In the visible spectrum, SiN has excellent optical properties compared to several other materials. SiN is transparent in the complete visible to near infrared (NIR) wavelength range, is compatible with standard complementary metal-oxide-semiconductor (CMOS) processing for low-cost mass fabrication, has a relatively high refractive index (n∼1.9-2.1) and has a low temperature sensitivity. Moreover, low-temperature plasma-enhanced chemical vapor deposition (PECVD) silicon nitride allows for integration of photonic circuits monolithically in back end of line (BEOL) of CMOS chips, which further facilitates use of silicon nitride in waveguides.

Silicon nitride light waveguides have been used in various sensing applications. In particular, when using a photonic circuit in a biosensing application, a biological coating may be applied directly on the light waveguide material or measurements may be performed directly on bare waveguide material. It is therefore of importance to have a well-controlled process of manufacturing a photonic circuit in order to enable accurate measurements to be performed using the photonic circuit.

In D. T. Krick, P. M. Lenahan, J. Kanicki, "Electrically active point defects in amorphous silicon nitride: An illumination and charge injection study", Journal of Applied Physics, vol. 64, no. 7, pp. 3558-3563, 1988, it is observed a strong correlation between changes in density of paramagnetic silicon "dangling-bond" centers and changes in space-charge density in amorphous silicon nitride films subjected alternately to illumination and both positive- and negative-charge injection. It is demonstrated that ultraviolet illumination annihilates space charge and creates stable paramagnetic centers in silicon nitride. These centers can be passivated with a 1-h anneal at 250ºC.

Cirino et al "Simulation and Fabrication of Silicon Nitride Microring Resonator by DUV Lithography", 2016 31st Symposium on Microelectronics Technology and Devices (SBMicro), IEEE, 29 August 2016, pages 1-4 and Gorin et al: "Fabrication of silicon nitride waveguides for visible-light using PECVD: a study of the effect of plasma frequency on optical properties", Optics Express, vol. 16, no. 18, 1 September 2008 disclose methods for manufacturing a silicon nitride light waveguide.

### Summary

An objective of the present inventive concept is to provide a method for manufacturing a photonic circuit including a silicon nitride light waveguide so as to enable accurate control of light waveguide properties in the manufactured photonic circuit.

These and other objectives of the present inventive concept are at least partly met by the invention as defined in the independent claims. Preferred embodiments are set out in the dependent claims.

The method is based on an insight that during manufacturing of the photonic circuit, charge traps in the silicon nitride light waveguide may be populated by charge carriers, i.e. electrons or electron holes. The method is further based on an insight that a silicon nitride light waveguide having populated charge traps may exhibit propagation loss of light through the silicon nitride light waveguide, due to light being absorbed by charge carriers in the populated charge traps for exciting the charge carriers.

Thus, according to the invention, a method of manufacturing of a photonic circuit includes exposing the silicon nitride light waveguide to a charge carrier exciting condition for exciting electrons from charge traps in the silicon nitride light waveguide to the conduction band and electron holes from charge traps in the silicon nitride light waveguide to the valence band. By exciting electrons and electron holes, the charge carriers may recombine with localized opposite charge carriers so that the charge traps in the silicon nitride light waveguide may be depopulated. Also, free electrons and holes may be trapped by defect states with energies not accessible by a working wavelength of light to be guided through the light waveguide such as not to cause propagation loss in the light waveguide.

The depopulation of charge traps may imply that the manufactured photonic circuit has expected and reproducible light propagation characteristics. This implies that photonic circuits manufactured by means of the method are reliable and different photonic circuits may provide similar measurement results. Hence, the photonic circuits may be used in sensitive measurement conditions and may be particularly useful for measurements where characteristics of light propagation may affect measurement results, such as in biosensing applications, wherein a biological coating may be applied directly on the light waveguide material or measurements may be performed directly on bare waveguide material.

The processing of the structure for forming the photonic circuit may comprise numerous different steps depending on the exact type of photonic circuit to be manufactured and other components to be formed on the substrate. The processing may include patterning steps for patterning the light waveguide or patterning other components on the substrate. The processing may also include intermediate or final cleaning steps for cleaning a surface on the substrate, e.g. for removing unwanted residues of material on the substrate. The processing may further include inspecting steps for inspecting the photonic circuit during manufacturing or after a final structure has been formed. Any such step may include that the structure is exposed to electromagnetic radiation, such that electrons are excited to a conduction band or electron holes are excited to a valence band in the silicon nitride material. The charge carriers, electrons or electron holes, may be trapped in local charge traps formed in the silicon nitride material and having a lower energy level than the conduction/valence band.

The processing may include exposing the structure to ultraviolet light from ultraviolet lamps, e.g. for cleaning of a surface, for inspection purposes, or for patterning purposes, such as in ultraviolet lithography.

The processing may include exposing the structure to plasma treatments, which may include the structure being exposed to ultraviolet light. Plasma treatments may be used e.g. in cleaning processes or in deposition or patterning processes of the structure.

Also, the handling of the structure comprising the silicon nitride light waveguide may include that the silicon nitride light waveguide is exposed to ultraviolet light in any other matter, as part of an intentional processing of the structure or as an unintended or accidental consequence during processing of the structure. For instance, exposure to sunlight may imply that the structure is exposed to (small amounts of) ultraviolet light. Further, light from gas discharge lamps may include ultraviolet light exposing the structure.

By means of intentionally exposing the silicon nitride light waveguide to the charge carrier exciting condition, any charge carriers in charge traps in the silicon nitride light waveguide may be excited and may eventually recombine or fall back to an energy level which may not be excited by a working wavelength of light to be guided in the light waveguide so that the charge traps in the silicon nitride light waveguide are depopulated fully or at least partially, e.g. to an acceptable level.

The exposing of the silicon nitride light waveguide to the charge carrier exciting condition may be performed after all steps that may cause population of charge traps in the silicon nitride light waveguide have been performed. Thus, the exposing of the silicon nitride light waveguide to the charge carrier exciting condition may be performed as a last step before shipping of the photonic circuit.

In some applications, the exposing of the silicon nitride light waveguide to the charge carrier exciting condition may be performed before a device including the photonic circuit is finalized. In some embodiments, the exposing of the silicon nitride light waveguide to the charge carrier exciting condition may be performed before packaging of a chip including the photonic circuit. In some embodiments, exposing of the silicon nitride light waveguide to the charge carrier exciting condition may be performed any time after a top oxide cladding is provided on the structure (which may protect the silicon nitride light waveguide from being exposed to electromagnetic radiation having an energy larger than the material bandgap). For instance, in some embodiments, the exposing of the silicon nitride light waveguide to the charge carrier exciting condition may be performed before dicing of a substrate.

The structure being exposed to electromagnetic radiation having an energy sufficiently large to excite electrons to a conduction band in the silicon nitride light waveguide should be construed as the structure being exposed to any type of electromagnetic radiation which enables electrons to be excited in such manner that electrons may reach the conduction band in the silicon nitride light waveguide. The energy may be larger than a material bandgap in the silicon nitride material, which bandgap may be somewhat dependent on characteristics of the silicon nitride material and may also differ at an interface of the silicon nitride material to adjacent materials and at a distance from the interface. Typically, the energy may correspond to light of an ultraviolet wavelength or shorter. The energy may be larger than a potential barrier in a material adjacent to the silicon nitride material. For instance, the energy may be sufficient overcome a potential barrier in an interface between a silicon layer and a silicon dioxide layer, such that electrons may be excited into a conduction band of the silicon dioxide layer and may then reach the silicon nitride light waveguide which may be arranged on the silicon dioxide layer.

As used herein, silicon nitride or abbreviation SiN is used to designate a compound of elements silicon and nitrogen and should not be construed as an indication of the chemical combination of the elements. On the contrary, silicon nitride will typically form a chemical combination with the formula Si₃N₄, but the silicon nitride light waveguide may be formed from silicon-rich silicon nitride that is non-stoichiometric, such that a ratio between silicon and nitrogen is not exactly 3:4 but somewhat higher. However, as used herein, the term silicon nitride or abbreviation SiN should be construed to cover any combination of mainly silicon and nitrogen, in any silicon nitride phase and in varying degrees of purification, possibly including trace elements of other materials.

According to an embodiment, the exposing of the silicon nitride light waveguide to the charge carrier exciting condition comprises illuminating the structure with light having an energy larger than an energy difference between a charge trap energy level and a conduction band energy level or a valence band energy level, the light having an energy smaller than a material bandgap in the silicon nitride light waveguide.

The light may have an energy sufficient to excite charge carriers from the charge traps, while not corresponding to the material bandgap (so as to prevent causing new charge carriers to be trapped in the charge traps).

The exposing of the silicon nitride light waveguide to light may imply that the structure is generally exposed to light. This implies that a simple set-up may be used for providing the exposing of the silicon nitride light waveguide to light. Also, a plurality of silicon nitride light waveguides on a common photonic circuit may be simultaneously exposed to light in a simple manner.

According to another embodiment, the exposing of the silicon nitride light waveguide to the charge carrier exciting condition comprises transmitting light through the light waveguide, wherein the light has an energy larger than an energy difference between a charge trap energy level and a conduction band energy level or a valence band energy level, the light having an energy smaller than a material bandgap in the silicon nitride light waveguide.

The transmitting of light through the light waveguide may ensure that light reaches the silicon nitride light waveguide in order to excite charge carriers. For instance, the transmitting of light through the light waveguide may be performed, e.g. by coupling light into the light waveguide through an input coupler, even if a layer has been formed covering the silicon nitride light waveguide.

According to an embodiment, the exposing of the silicon nitride light waveguide to the charge carrier exciting condition comprises exposing the structure to a temperature in a range of 150-400°C.

By exposing the structure to a high temperature, trapped charge carriers may be excited by thermal activation. By exposing the structure to a high temperature for a period of time, it may be ensured that the charge traps are depopulated fully or at least to an acceptable level.

The exposing of the silicon nitride light waveguide to the charge carrier exciting condition may include one or more of the illuminating the structure with light, transmitting light through the light waveguide, and exposing the structure to a high temperature, such that a single step may be performed or a combination of these steps may be performed.

According to an embodiment, the processing of the structure comprises the structure being exposed to ultraviolet light. The structure being exposed to ultraviolet light implies that electrons are excited to a conduction band in the silicon nitride light waveguide, such that charge traps in the silicon nitride may be populated.

According to an embodiment, the processing of the structure comprises patterning of the silicon nitride light waveguide on the substrate including a lithography step exposing the structure to ultraviolet light. Hence, by performing the lithography step, electrons may be excited to a conduction band in the silicon nitride light waveguide, such that charge traps in the silicon nitride may be populated. This implies that after such processing, the silicon nitride light waveguide needs to be exposed to the charge carrier exciting condition in order to depopulate the charge traps.

It should be realized that it is not always necessary to perform patterning including exposing the structure to ultraviolet light. For instance, the structure may not always need to include details of a size so small that ultraviolet light exposure is needed. Further, in some embodiments, a slab silicon nitride layer may form a silicon nitride light waveguide, such that there may be no need of patterning the silicon nitride light waveguide.

According to an embodiment, the processing of the structure comprises cleaning of a surface of the structure including at least one of a UV ozone cleaning step and a plasma cleaning step including exposing the structure to ultraviolet light.

Cleaning of a surface of the structure may be needed for many different purposes. For instance, cleaning may be needed for removing dicing tape residues and photoresist and developer contamination. When performing cleaning steps including exposing the structure to ultraviolet light, electrons may be excited to a conduction band in the silicon nitride light waveguide, such that charge traps in the silicon nitride may be populated. This implies that after such processing, the silicon nitride light waveguide needs to be exposed to the charge carrier exciting condition in order to depopulate the charge traps.

According to an embodiment, the structure comprises at least one input coupler arranged in a common plane with the patterned silicon nitride waveguide, wherein the input coupler is configured for coupling light into the silicon nitride light waveguide.

The silicon nitride light waveguide may thus be formed with an input coupler, which may facilitate that light is coupled into the silicon nitride light waveguide for transmitting light in the silicon nitride light waveguide of the photonic circuit.

According to an embodiment, the structure comprises an oxide layer on the patterned silicon nitride light waveguide for forming an oxide cladded waveguide. The oxide cladding may define controlled characteristics of light propagation through the silicon nitride light waveguide.

According to an embodiment, the depositing of silicon nitride comprises plasma-enhanced chemical vapor deposition of a silicon nitride layer.

This may be particularly useful as plasma-enhanced chemical vapor deposition of the silicon nitride layer may be performed in low temperature and may allow forming of the silicon nitride layer in back end of line processing of a CMOS structure.

According to an embodiment, the method further comprises applying a biological coating on the silicon nitride light waveguide. The applying of a biological coating on the silicon nitride light waveguide may be used in manufacturing of photonic circuits for biosensing applications. For instance, the biological coating may be used for binding molecules or substances of interest to a surface close to the silicon nitride light waveguide.

The applying of a biological coating may require that a surface to which the biological coating is applied is cleaned before the biological coating is applied. Hence, when applying a biological coating, the structure may be exposed to a cleaning step in which electrons may be excited to the conduction band in the silicon nitride light waveguide. Therefore, when using a biological coating, the exposing of the silicon nitride light waveguide to the charge carrier exciting condition may be particularly needed.

According to an embodiment, the applying of the biological coating is performed after the exposing of the silicon nitride light waveguide to a charge carrier exciting condition. Thus, the silicon nitride light waveguide may be exposed to the charge carrier exciting condition, e.g. after a cleaning step preparing a surface for applying of the biological coating, and before the biological coating is applied.

According to the first aspect, the exposing of the silicon nitride light waveguide may be part of a manufacturing method, such that photonic circuits may be manufactured and sold being prepared for direct use. The photonic circuits may allow reliable and reproducible measurements to be performed avoiding propagation loss in the silicon nitride light waveguide to affect the measurements. This implies that a user of the photonic circuit may not need to prepare the photonic circuit before performing measurements, such that use of the photonic circuit does not require advanced knowledge or handling of photonic circuits.

However, in addition to, or alternatively to the manufacturing method, a photonic circuit may be prepared before performing measurements in order to ascertain that charge traps in the silicon nitride light waveguide are depopulated fully or to an acceptable level before measurements are performed. Thus, the photonic circuit may be set to a default condition so as to allow comparison between measurements performed with different specimens of photonic circuits.

The preparation of the photonic circuit before performing measurements includes exposing the silicon nitride light waveguide to the charge carrier exciting condition. Measurements using the photonic circuit may only be started after the step of exposing.

The exposing of the silicon nitride light waveguide to the charge carrier exciting condition may include any or a combination of illuminating the structure with light, transmitting light through the light waveguide, and exposing the structure to a high temperature, as discussed above.

### Brief description of the drawings

The above, as well as additional objects, features and advantages of the present inventive concept, will be better understood through the following illustrative and non-limiting detailed description, with reference to the appended drawings. In the drawings like reference numerals will be used for like elements unless stated otherwise.
Fig. 1 is a flow chart of a method for manufacturing of a photonic circuit.
Figs 2a-b are schematic views illustrating population and depopulation, respectively, of charge traps in a silicon nitride light waveguide.
Fig. 3 is a flow chart of a method for preparing a photonic circuit for measurements.
Fig. 4 is a schematic view of a set-up of silicon nitride light waveguides for tests.
Figs 5a-b are charts illustrating measured propagation loss in silicon nitride light waveguides before and after oxygen plasma and ultraviolet ozone cleaning, respectively.
Figs 6a-b are charts illustrating effects of depopulating charge traps using activation by light irradiation in relation to oxygen plasma and ultraviolet ozone cleaning, respectively.
Figs 6c-d are charts illustrating effects of depopulating charge traps using thermal activation in relation to oxygen plasma and ultraviolet ozone cleaning, respectively.
Figs 7a-b are charts illustrating effects of depopulating charge traps using thermal activation wherein a period of time of thermal activation and a temperature of thermal activation are varied, respectively.
Fig. 8 is a chart illustrating wavelength dependency of propagation loss.
Fig. 9 is a chart illustrating long term stability of silicon nitride light waveguides.

### Detailed description

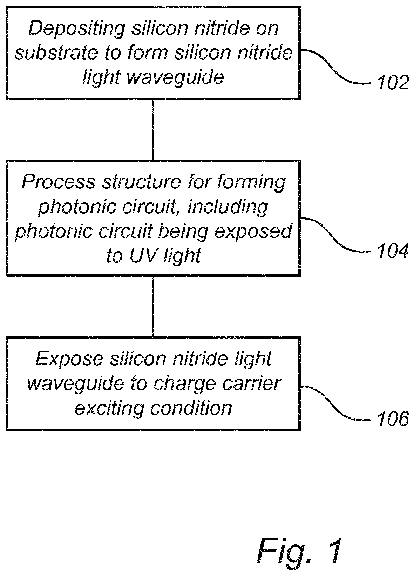

Referring now to Fig. 1, a method for manufacturing of a photonic circuit including a silicon nitride light waveguide will be described. The method comprises forming a structure on a substrate, e.g. a semiconductor substrate, wherein the structure comprises a silicon nitride light waveguide implementing a photonic circuit. The structure may be formed using a number of different manufacturing steps commonly used in complementary metal-oxide-semiconductor (CMOS) manufacturing, such as depositing, patterning, etching, and cleaning.

Thus, the method includes depositing 102 silicon nitride on the substrate such that a silicon nitride light waveguide may be formed in the structure. The silicon nitride may be patterned for forming a specific desired shape of the silicon nitride light waveguide. However, in some embodiments, a slab silicon nitride layer may form the silicon nitride light waveguide, such that there may be no need of patterning the silicon nitride light waveguide.

As mentioned, the structure may be processed 104 for forming the photonic circuit and, possibly, associated circuitry to be arranged on the substrate. The processing may include, after the silicon nitride has been deposited on the substrate any of the above mentioned steps of depositing, patterning, etching and cleaning. Also, the structure may be inspected between processing steps or after the processing steps to form a complete structure has been formed.

The processing steps may include that the structure including the silicon nitride is exposed to electromagnetic radiation. The electromagnetic radiation may have an energy sufficiently large to excite electrons to a conduction band in the silicon nitride light waveguide. When electrons are excited to the conduction band, some electrons may be trapped in charge traps within the silicon nitride light waveguide. Thus, charge traps may be populated in the silicon nitride light waveguide.

Similarly, the electromagnetic radiation may excite electron holes to a valence band in the silicon nitride light waveguide. Some electron holes may also be trapped in charge traps within the silicon nitride light waveguide.

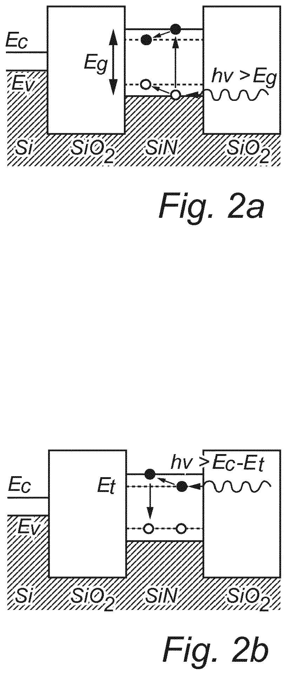

In Fig. 2a, an ideal band diagram of a typical waveguide configuration consisting of a SiO₂/SiN/SiO₂ stack on top of a doped silicon wafer is shown. Without applying an electric potential, photoinjection of free carriers into the SiN is possible via direct generation of electron-hole pairs with light energy exceeding the SiN bandgap energy. The bandgap of the SiN waveguide material is about 5 eV, which implies that ultraviolet radiation generated in different processing steps (deep ultraviolet lithography, radiation from cleaning and etching plasmas) or cleaning steps (ultraviolet ozone cleaning, oxygen plasma cleaning) can initiate direct generation of electron-hole pairs across the SiN bandgap. Charge carrier trapping centra in the irradiated region can capture the generated electron and holes after their thermalization.

If the silicon nitride light waveguide is used for propagating light in the light waveguide, light may be absorbed by electrons in the charge traps in order to again excite the electrons to the conduction band or electron holes to the valence band. This implies that propagation loss may occur in the silicon nitride light waveguide, which may affect functionality of the photonic circuit. In particular, if measurements are to be performed using the photonic circuit, results of the measurements may be affected by the propagation loss such that measurements may not be reliable and measurements made by different photonic circuits are not comparable.

The method for manufacturing of the photonic circuit may therefore further comprise exposing 106 the silicon nitride light waveguide to a charge carrier exciting condition. The charge carrier exciting condition may excite electrons from charge traps in the silicon nitride light waveguide to the conduction band and electron holes from charge traps in the silicon nitride light waveguide to the valence band. When the charge carriers are excited, electrons may move inside the conduction band and electron holes may move inside the valence band. The charge carriers may then be trapped again in the charge traps and later be excited to the conduction band and the valence band, respectively, if the charge carrier exciting condition is maintained. Some electrons may recombine with localized electron holes in charge traps. Similarly, some electron holes may recombine with localized electrons in charge traps. Thereby, the optically active charge traps may eventually be depopulated such that the silicon nitride light waveguide only contains few charge carriers in defect states that can be optically excited by the working wavelength of light to be guided through the light waveguide.

In Fig. 2b, one charge trap depopulation method is illustrated. In thermal equilibrium, all lower energy defect levels are completely occupied. Therefore, a photon with an energy far below the SiN bandgap cannot excite an electron from the valence band into the completely occupied low energy defect states. Neither has it sufficient energy to excite an electron from the highest filled defect state into the conduction band. Therefore, at thermal equilibrium, no optical absorption will take place for light energies far below the SiN bandgap. By means of a UV exposure with energies comparable to the SiN bandgap, electrons from both the defect states as from the SiN valence band can be directly excited into the conduction band where they become mobile and can be trapped by any accessible defect center. This process induces single or double occupied states in the shallow energy levels, allowing optical excitation of electrons with light energies down to ∼1.4 eV (depending on the trap state energy and the width of the defect energy band). Rendering the SiN back to a non-absorbing material requires activation of the trapped electrons or holes so they can move into the mobility band and be retrapped by another defect. This continues until all accessible electrons fall down to an energy level that cannot be excited with the working wavelength. This process of activation and consecutive defect depopulation can be achieved both by thermal annealing and by low energy optical excitation.

Thus, a way to excite trapped electrons into the conduction band can be achieved by thermal activation. In absence of an electric field, the number of free electrons at equilibrium in the conduction band is proportional to *e*^{-*U*₀/*k_{b}T*}, where U₀ is the trap ionization energy, k_{B} is the Boltzmann constant and T is the temperature. Just as in the case of optical depopulation, thermal activation continues until the silicon nitride material reaches a thermal equilibrium.

The exposing of the silicon nitride light waveguide to the charge carrier exciting condition may thus prepare the photonic circuit such that propagation loss of light in the silicon nitride light waveguide due to exciting of trapped charge carriers is reduced to a minimum or at least to an acceptable level. The photonic circuit may thus be shipped and delivered in a well-defined, ready-to-use state such that a user may reliably use measurements performed by the photonic circuit and the user may directly take the photonic circuit into use.

The exposing of the silicon nitride light waveguide to the charge carrier exciting condition may be performed as a final step of manufacturing such that any trapped charge carriers may be excited. However, the exposing of the silicon nitride light waveguide to the charge carrier exciting condition may also or alternatively be performed when the structure will no longer be exposed to electromagnetic radiation that may excite electrons to the conduction band in the silicon nitride light waveguide for populating the charge traps.

For instance, the silicon nitride light waveguide could at least in some embodiments be exposed to the charge carrier exciting condition before the substrate is diced and/or before encapsulating the structure in a packaging step.

In the processing of the structure comprising the silicon nitride light waveguide, the structure may be exposed to ultraviolet light, which may have sufficient energy for exciting electrons to the conduction band.

The exposure to ultraviolet light may occur in any step using an ultraviolet lamp, e.g. as used in cleaning steps, in patterning steps using ultraviolet lithography, or in inspection steps where the ultraviolet light is used for inspection purposes.

The exposure to ultraviolet light may also or alternatively occur in processing steps using plasmas. Plasma may generate ultraviolet light, depending on gases involved in forming the plasma. For instance, ultraviolet light may be generated in etch processes using plasma, in plasma-enhanced deposition techniques and in plasma-based cleaning.

The silicon nitride light waveguide may be exposed to the electromagnetic radiation having sufficient energy even if the processing step is not directly related to patterning or forming of the silicon nitride light waveguide. When the processing step is performed after the silicon nitride has been deposited on the substrate, the electromagnetic radiation may excite electrons to the conduction band or electron holes to the valence band for populating charge traps in the silicon nitride light waveguide.

The silicon nitride light waveguide may also be exposed to the electromagnetic radiation having sufficient energy in other ways during processing of the structure. The exposure need not necessarily be based on an active processing step. For instance, the silicon nitride light waveguide may be exposed to ultraviolet light by means of the structure being exposed to sunlight (including a fraction of ultraviolet light). Further, light from gas discharge lamps may include ultraviolet light exposing the structure. Also, light may be generated by electric discharge which may be used e.g. in welding or fiber splicing steps. It should be realized that the exposure to electromagnetic radiation may also occur in other ways.

The exposing of the silicon nitride light waveguide to the charge carrier exciting condition may be performed in several different ways. The silicon nitride light waveguide should be exposed to energy allowing the trapped charge carriers to be excited. However, the energy should be smaller than a material bandgap in the silicon nitride light waveguide, such that new electrons are not excited into the conduction band so that the charge traps are not repopulated by new charge carriers.

According to an embodiment, the exposing of the silicon nitride light waveguide to the charge carrier exciting condition may comprise illuminating the structure with light having an energy larger than an energy difference between a charge trap energy level and a conduction band energy level or a valence band energy level. The structure may thus be exposed to flood illumination such that the entire structure is exposed by the illuminated light. There may be no need to direct the light to reach a specific part of the structure. Rather, the entire structure may be exposed meaning that the silicon nitride light waveguide may also be exposed to the illumination light.

Flood illumination may be advantageously used when the silicon nitride light waveguide is exposed on a surface of the structure. However, if a non-transparent layer is arranged on the silicon nitride light waveguide, flood illumination may not be suitable.

The illumination light may have a wavelength in a range of visible light. For instance, a wavelength around 635 nm may be used. In particular, the illumination light may have a wavelength corresponding to or being shorter than a working wavelength which is to be guided through the waveguides in use of the photonic circuit. Thus, trapped charge carriers of all trap states which can be accessed by the energy of the light of the working wavelenght and, hence, may affect propagation of the wavelength of interest may be excited.

According to an embodiment, the exposing of the silicon nitride light waveguide to the charge carrier exciting condition may comprise transmitting light through the silicon nitride light waveguide. This may ensure that illumination light reaches the silicon nitride light waveguide and that charge carriers in the silicon nitride light waveguide may be excited so that the charge traps are depopulated.

The transmitting of light through the silicon nitride light waveguide may use a wavelength in a range of visible light. For instance, a wavelength around 635 nm may be used. In particular, the transmitted light may have a wavelength corresponding to a wavelength which is to be guided through the waveguides in use of the photonic circuit. Thus, trapped charge carriers which may affect propagation of the wavelength of interest may be excited.

According to an embodiment, the exposing of the silicon nitride light waveguide to the charge carrier exciting condition may comprise exposing the structure to a high temperature. Thus, the entire structure may be arranged in a heated environment such that the structure including the silicon nitride light waveguide is exposed to the high temperature.

The high temperature may increase the number of charge carriers in the conduction band/valence band compared to the number of charge carriers in the charge traps. By exposing the silicon nitride light waveguide to the high temperature for a period of time, the charge traps may thus be depopulated.

The lower the temperature that the silicon nitride light waveguide is exposed to, the longer period of time the silicon nitride light waveguide may need to be exposed to the high temperature. Also, the period of time that may be needed may vary depending on a shape or thickness of the silicon nitride light waveguide. The silicon nitride light waveguide may be exposed to the high temperature for a substantial period of time so as to ensure that the population of the charge traps has decreased below a desired level.

According to the invention the high temperature is in a range of 150-400ºC. Higher temperatures may be contemplated. However, undesired other effects due to the high temperature should be avoided and may be a factor to take into account when choosing the temperature.

The silicon nitride light waveguide may be exposed to the high temperature for a period of time ranging from a few minutes (such as 5 minutes) to more than 1 hour. It should be realized that the silicon nitride light waveguide may be exposed to the high temperature for a much longer period of time than strictly necessary for achieving an acceptable level of depopulation of charge traps. For instance, the silicon nitride light waveguide may be exposed for several hours or even days to the high temperature so as to ensure that the acceptable level is reached.

The silicon nitride light waveguide may be exposed to a combination of two or more charge carrier exciting conditions. For instance, the silicon nitride light waveguide may be exposed to both flood illumination and a high temperature.

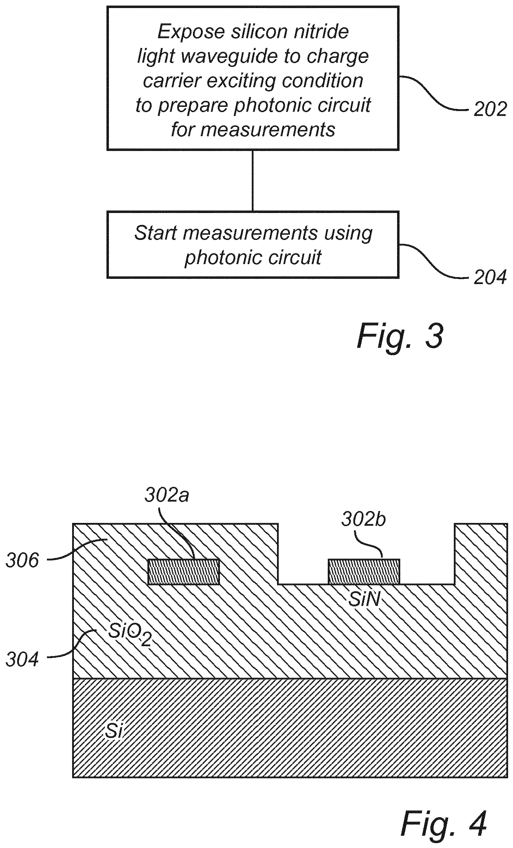

Referring now to Fig. 3, a method for performing measurements using a photonic circuit including a silicon nitride light waveguide will be described.

As explained above, charge carriers in charge traps in the silicon nitride light waveguide may affect propagation loss of the silicon nitride light waveguide and may therefore also affect results of measurements.

The photonic circuit including the silicon nitride light waveguide may be exposed to the charge carrier exciting condition already during manufacturing, which may enable the photonic circuit to be ready-to-use when delivered to a user.

However, if the silicon nitride light waveguide has not been exposed to the charge carrier exciting condition during manufacturing, the silicon nitride light waveguide may be exposed 202 to the charge carrier exciting condition as a preparation step to prepare the photonic circuit for the measurements to be performed with the photonic circuit.

Even if the silicon nitride light waveguide has been exposed to the charge carrier exciting condition during manufacturing, the silicon nitride light waveguide may anyway be exposed 202 to the charge carrier exciting condition as a preparation step to prepare the photonic circuit for the measurements to be performed. The preparation step may ensure that charge traps are depopulated and may reduce effects of the charge traps being accidentally populated after manufacturing and before performing measurements, e.g. during transport to a buyer of the photonic circuit.

Advanced users may ensure that the silicon nitride light waveguide is always exposed to the charge carrier exciting condition before measurements are performed. Thus, the silicon nitride light waveguide may always be exposed to same or at least very similar conditions before the measurements are started.

After the exposing of the silicon nitride light waveguide to the charge carrier condition, the measurements using the photonic circuit may be started 204. The measurements may be performed shortly after the exposing of the silicon nitride light waveguide to the charge carrier exciting condition to avoid any effect of the silicon nitride light waveguide being (accidentally) exposed to electromagnetic radiation having an energy sufficiently large to excite electrons to a conduction band in the silicon nitride light waveguide before the measurements are performed.

The preparation step may ensure that the measurements performed may provide reliable measurement results and results which may be compared between different sessions, possibly performed with different specimens of the photonic circuit. In particular, comparable measurement results may be obtained if the photonic circuit is always exposed to same or at least very similar conditions before the measurements are started.

The exposing of the silicon nitride light waveguide to the charge carrier exciting condition may be achieved using any one of or a combination of the steps described above in relation to manufacturing of the photonic circuit. Thus, flood illumination, transmitting of light through the silicon nitride light waveguide and/or exposing the silicon nitride light waveguide to a high temperature may be performed.

The photonic circuit including the silicon nitride light waveguide may have different characteristics depending on an application in which the photonic circuit is to be used. Thus, the photonic circuit may have many different shapes and forms. The silicon nitride light waveguide may be patterned to provide a desired pattern in which light is guided. A plurality of different waveguides or different arms within the silicon nitride light waveguide may be provided. However, the silicon nitride light waveguide may also be provided as a layer in which light is propagated.

The silicon nitride light waveguide may be used for transporting light towards a sample on which measurements are to be made and/or transporting light acquired from a sample towards a sensor for detecting intensity of light.

The silicon nitride light waveguide may be intended for transporting visible light. This is of special interest as silicon waveguides may normally not be used for transporting visible light due to high absorbance levels. However, the silicon nitride light waveguide could also or alternatively be used for transporting other wavelengths of light, such as near infrared or infrared wavelengths.

The photonic circuit may comprise one or more input couplers and/or one or more output couplers for coupling light into the silicon nitride light waveguide and out of the silicon nitride light waveguide. This may ensure that light is controlled to be coupled into/out of the silicon nitride light waveguide which may be formed in a plane of the structure including the silicon nitride light waveguide.

The photonic circuit may be used in a biosensor application. The silicon nitride light waveguide or a portion thereof may then be provided with a biological coating deposition, e.g. for ensuring that molecules of interest attach to the biological coating and may then be exposed to light transmitted through the silicon nitride light waveguide.

In particular, a surface of the structure may need to be cleaned before the biological coating deposition in order to ensure that a desired contact angle may be achieved for the biological coating onto the surface of the structure. Cleaning may be needed to remove any dicing tape residues and photoresist and developer contamination. Cleaning of the surface may include oxygen plasma and/or ultraviolet ozone cleaning and may hence expose the silicon nitride light waveguide to ultraviolet light. The silicon nitride light waveguide may therefore also need to be exposed to the charge carrier exciting condition before or after applying of the biological coating.

Some tests have been made in order to quantify and show an effect of exposing silicon nitride light waveguide to charge carrier exciting conditions. In these tests, plasma-enhanced chemical vapor deposition (PECVD) silicon nitride (SiN) strip waveguides 302 have been fabricated in a 200 mm CMOS pilot line. A schematic overview of the waveguide geometry is shown in Fig. 4. The waveguide is provided with PECVD SiO₂ bottom 304 and top cladding 306 having a thickness of respectively 2300 nm and 1000 nm. A thickness of the PECVD SiN waveguides 302 is 220 nm and a width of the waveguides 302 is 340 nm in case of oxide cladding (left waveguide 302a) and 480 nm in case of air cladding (right waveguide 302b). Air cladded waveguides 302b are manufactured by opening the top oxide cladding above the SiN waveguide. All waveguides and grating couplers are designed for 635 nm wavelength of light. Used samples contain 8 air cladded waveguide sets, each containing 16 different waveguide lengths (0 - 4.5 cm) to determine waveguide propagation loss in air. Each sample also has 2 smaller oxide cladded waveguide sets with 4 different waveguide lengths (1 - 4 cm) to determine propagation loss for oxide cladded waveguides. To measure the structures, a custom-made microscope with an automated fiber coupler is used. All output couplers from a single set can be measured in a single camera frame, allowing determination of both the oxide cladded and air-cladded propagation loss for all waveguide sets.

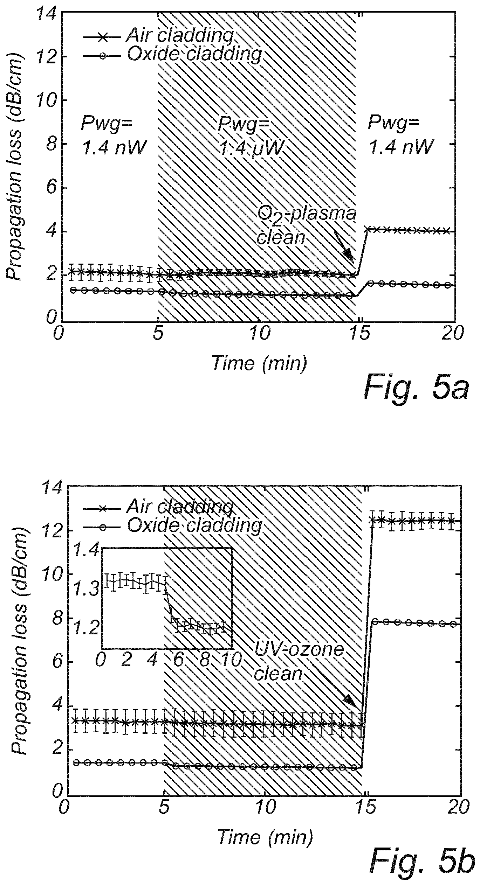

In Figs 5a-b, measured propagation loss before and after oxygen plasma and ultraviolet ozone cleaning is shown, respectively. The propagation loss was measured for air cladded waveguides (marked by "x") and oxide cladded waveguides (marked by "o") before and after the cleaning step. For both measurements in Figs 5a-b, the propagation loss was measured for a low power of 1.4 nW/ waveguide (white background in Figs 5a-b) and a higher power of 1.4 µW/ waveguide (shaded background in Figs 5a-b) before cleaning. After 15 minutes, the samples were taken out of the measurement setup and cleaning was performed, indicated by a break in the x-axis of Figs 5a-b. Right after the cleaning, the samples were reinstalled on the measurement setup and the propagation loss was extracted again at low optical power (1.4 nW/ waveguide). After both cleaning procedures, a very strong propagation loss increase can be observed for the air cladded waveguides, and also for the cladded waveguides. After oxygen plasma cleaning (100 W, 2 sccm O₂, 50 mTorr, 30 min), a propagation loss increase from 2.1 to 4.2 dB/cm for air cladded waveguides is observed and from 1.2 to 1.7 dB/cm for oxide cladded waveguides is observed. This effect is even larger for UV-ozone cleaning (UVO-Cleaner ® model 144AX from Jelight Company, Inc, of Irvine, CA, 15 min), where a propagation loss increase from 3.2 to 12.5 dB/cm is observed for air cladding and from 1.2 to 7.9 dB/cm is observed for oxide cladding.

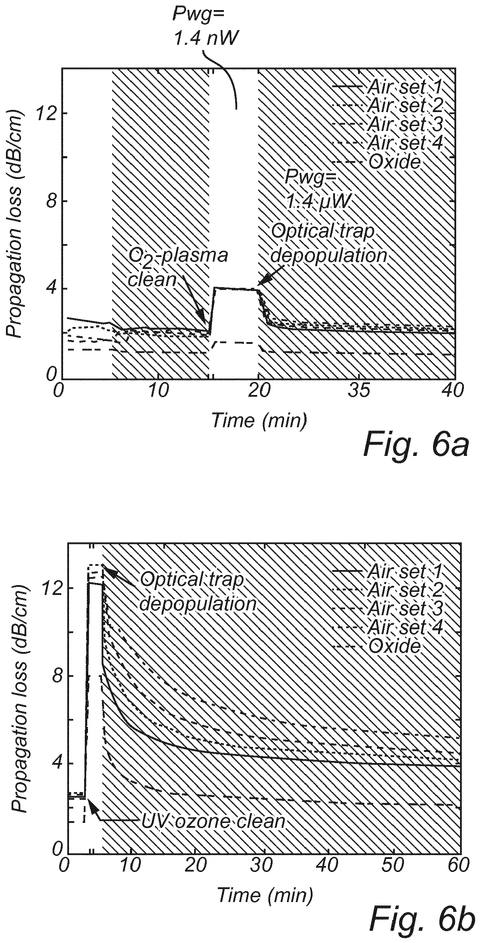

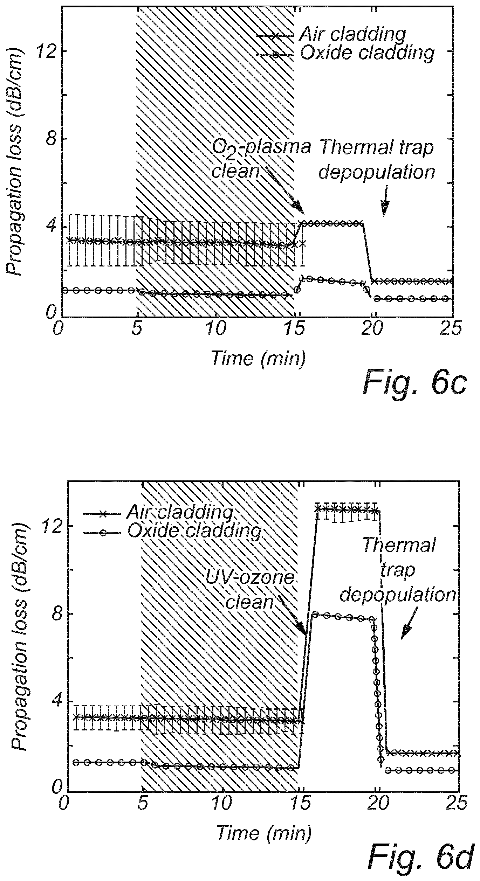

Two proposed ways of depopulating the charge traps, namely by thermal activation and activation by light irradiation, were tested to confirm the expected reduction in propagation loss due to the depopulation of the charge traps. In Figs 6a-b, the waveguide propagation loss is plotted before, during and after optical trap depopulation for respectively an oxygen plasma cleaned and a UV-ozone cleaned sample. As in the previous experiment, the input laser power for each waveguide was kept at 1.4 nW per waveguide (white background area in figures) for the first 5 minutes to have a baseline loss value for the uncleaned samples. The following 10 minutes, the laser power was increased to 1.4 µW per waveguide (shaded background area in figures). After the clean, during the first 5 minutes the laser power per waveguide was kept at 1.4 nW to assess the propagation loss value after cleaning. Subsequently the power was set back to 1.4 µW per waveguide and the evolution of the propagation loss as function of time was monitored. After both cleans, the loss decreases rapidly at a higher optical power as a function of time towards its initial value right before the clean. For optical depopulation, the four air cladded waveguide sets are plotted separately. Because the routing waveguide connecting the input grating coupler to the 4 waveguide sets have different lengths (2, 3, 4 and 5 cm for respectively set 1, 2, 3 and 4), the combination of the optical charge trap depopulation of both the connection waveguide and the waveguide set is observed. Therefore, a different rate of depopulation is observed for the 4 open clad waveguides. This is very clear in Fig. 6b, where the optical depopulation is shown after UV-ozone cleaning. As the same wavelength is used to release the charge traps as to probe the propagation loss, automatically the traps with the correct energy are targeted for trap state depopulation. Deeper trap states with activation energies up to 3 eV can be present at lower densities, but are not measured as they cannot be directly activated by 635 nm light and consequently do not have a large contribution to the propagation loss. When working with waveguides for low power applications, for example highly parallelized sensing platforms or fluorescence excitation at low powers to prevent photo bleaching, it is very important to perform a proper clean and depopulate the charge centra in order to start each experiment with the same initial condition.

In Figs 6c-d, the effect of thermal activation of filled traps is shown for respectively oxygen plasma and UV-ozone cleaning. In these measurement, the sample was baked for 65 minutes on a 300 °C hotplate under atmospheric pressure right after the clean. As all wells received the same treatment, the average propagation loss was plot with the standard deviation over the four wells as error bar. It is found that a high temperature thermal anneal after UV-ozone cleaning yields the lowest and most stable propagation loss value, combined with a very clean surface for biological coating or experiments, confirmed by contact angle measurements and Fourier-transform infrared (FTIR) spectroscopy. As fabricated, the standard deviation over the open clad waveguide sets on 8 different wells on a single chip is 0.93 dB/cm, while after UV ozone cleaning followed by thermal trap depopulation this is reduced to < 0.050 dB/cm. This indicates an advantage of both cleaning and depopulating the SiN charge traps before performing experiments, especially for low power measurements.

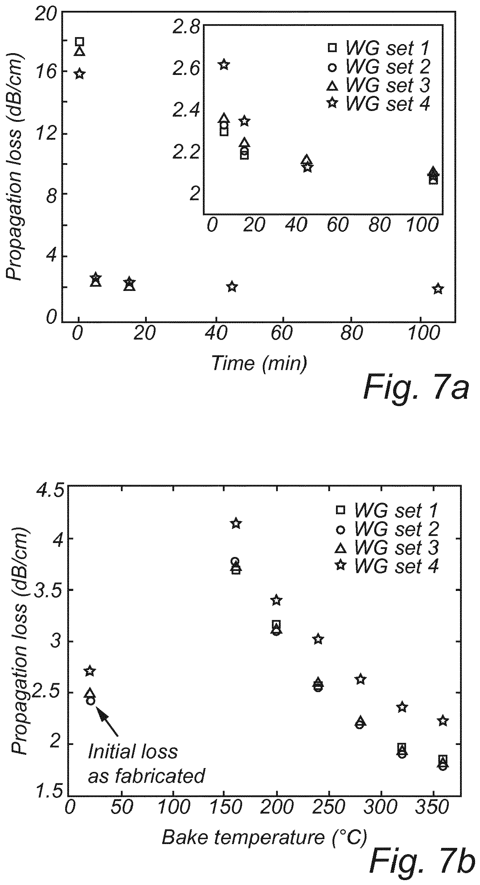

Thermal depopulation measurements were performed as a function of anneal time and temperature. The results are shown in Figs 7a-b, respectively. In Fig. 7a, the propagation loss of four air cladded sets are shown for baking at 330 °C after a UV-ozone clean for baking times of 0, 5, 15, 45 and 105 minutes. One can observe that most traps are emptied within the first 5 minutes. In the inset in Fig. 7a, the graph is shown without the initial values after cleaning, showing a very slow gradual increase towards an optimum propagation loss value. The same measurement is performed for a fixed time of 65 minutes for different temperatures ranging from 160° to 360°C on the same sample with a UV-ozone clean in between each measurement. The measured loss values are shown in Fig. 7b. After each clean, a propagation loss for air cladded waveguides of 12 to 18 dB/cm was measured right after cleaning, showing the reversibility of this process. Due to temperature restrictions of the hot plate, tests could only be made for temperatures up to 360 °C, but it is seen that above 300 °C the propagation loss starts converging to the minimal propagation loss value. Also, as we are working with low-temperature PECVD nitride, higher temperature annealing might result in permanent material changes.

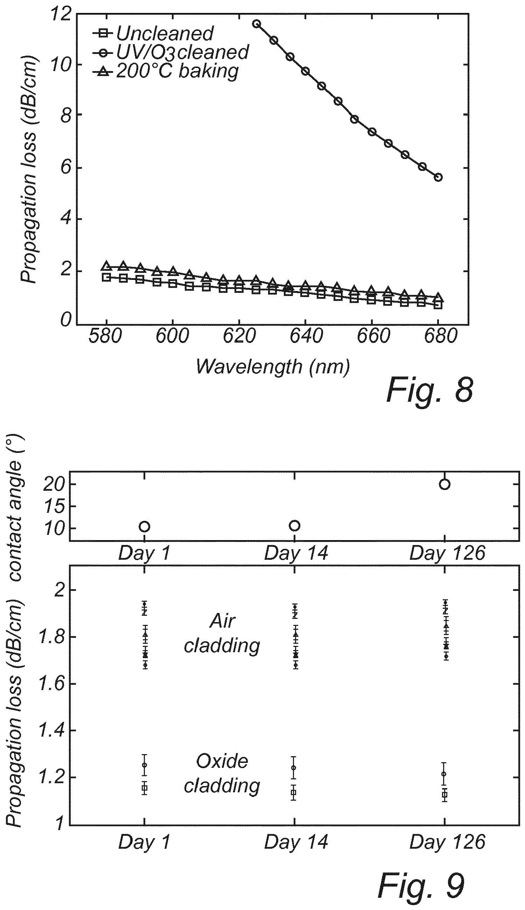

Wavelength dependent measurements can give direct information about the charge trap energies and densities in silicon nitride. Due to the limited wavelength range of the grating couplers, it was only possible to determine the propagation loss between 580 nm (2.14 eV) and 680 nm (1.82 eV). This range even reduces after performing the UV-ozone clean to 625 nm (1.98 eV) to 680 nm due to the very high propagation loss. The spectral data can be found in Fig. 8. For very low optical powers where the trap density can be considered constant, an increase of UV-induced propagation loss for increasing photon energy is seen, which is expected as more trap states can be accessed with higher energy photons.

In order to assess the long term stability of the SiN waveguides, a storage experiment was performed. A standard sample containing eight waveguide sets with air cladding and two sets of oxide cladded waveguides was cleaned in acetone (90 min in ultrasonic bath), hot isopropyl alcohol (20 min at 50 ºC) and received a UV-ozone treatment (15 min). After this clean, the sample was cured on a hot plate at 330 ºC for 90 minutes in order to depopulate the SiN charge traps. Both the contact angle of the sample and the propagation loss were measured on day 1, day 14 and day 126. Samples were packaged in a sample box made light-tight by aluminum foil and stored in a plastic bag containing a desiccant package in a freezer at -22 °C. This procedure was chosen in order to avoid surface contamination due to outgassing of the plastic of the sample box and plastic storage bag. For oxide cladded waveguides, the propagation loss change stays well inside the error bars of all measurements, so no significant change is observed, even after 126 days of storage. For most air cladded waveguides, a slightly elevated propagation loss is measured at day 126, which can be explained by organic contamination of the waveguide as is also indicated by the elevated contact angle measurement. It can be concluded that the SiN waveguide layer retains its electronic properties for at least 18 weeks after the cleaning and thermal depopulation procedure, when stored in a light-tight package. Organic contamination of the bare sample surface is very hard to avoid and was reduced to a minimum. However, a stable surface coating may be advantageous if samples require a reproducible surface condition after long term storage.

In the above the inventive concept has mainly been described with reference to a limited number of examples. However, as is readily appreciated by a person skilled in the art, other examples than the ones disclosed above are equally possible within the scope of the inventive concept, as defined by the appended claims.

## Claims

1. A method for manufacturing of a photonic circuit including a silicon nitride light waveguide; said method comprising:
depositing (102) silicon nitride on a substrate for forming a structure comprising a silicon nitride light waveguide (302) on a substrate;
processing (104) the structure for forming the photonic circuit;
wherein the processing (104) of the structure comprises the structure being exposed to electromagnetic radiation having an energy sufficiently large to excite electrons to a conduction band in the silicon nitride light waveguide (302);
the method further comprising exposing (106) the silicon nitride light waveguide (302) to a charge carrier exciting condition for exciting electrons from charge traps in the silicon nitride light waveguide (302) to a conduction band and electron holes from charge traps in the silicon nitride light waveguide (302) to a valence band for depopulating charge traps so as to reduce propagation loss of light through the silicon nitride light waveguide (302)
wherein the exposing (106) of the silicon nitride light waveguide (302) to the charge carrier exciting condition comprises illuminating the structure with light having an energy larger than an energy difference between a charge trap energy level and a conduction band energy level or a valence band energy level, the light having an energy smaller than a material bandgap in the silicon nitride light waveguide (302); or
wherein the exposing (106) of the silicon nitride light waveguide (302) to the charge carrier exciting condition comprises transmitting light through the light waveguide (302), wherein the light has an energy larger than an energy difference between a charge trap energy level and a conduction band energy level or a valence band energy level, the light having an energy smaller than a material bandgap in the silicon nitride light waveguide (302); or
wherein the exposing (106) of the silicon nitride light waveguide (302) to the charge carrier exciting condition comprises exposing the structure to a temperature in a range of 150-400°C.

2. The method according to claim 1, wherein the processing (104) of the structure comprises the structure being exposed to ultraviolet light.

3. The method according to claim 1 or 2, wherein the processing (104) of the structure comprises patterning of the silicon nitride light waveguide (302) on the substrate including a lithography step exposing the structure to ultraviolet light.

4. The method according to any one of the preceding claims, wherein the processing (104) of the structure comprises cleaning of a surface of the structure including at least one of a UV ozone cleaning step and a plasma cleaning step including exposing the structure to ultraviolet light.

5. The method according to any one of the preceding claims, wherein the structure comprises at least one input coupler arranged in a common plane with the silicon nitride light waveguide (302), wherein the input coupler is configured for coupling light into the silicon nitride light waveguide (302).

6. The method according to any one of the preceding claims, wherein the structure comprises an oxide layer (306) on the silicon nitride light waveguide (302) for forming an oxide cladded waveguide (302a).

7. The method according to any one of the preceding claims, wherein the depositing (102) of silicon nitride comprises plasma-enhanced chemical vapor deposition of a silicon nitride layer.

8. The method according to any one of the preceding claims, further comprising applying a biological coating on the silicon nitride light waveguide (302).

9. The method according to claim 8, wherein the applying of the biological coating is performed after the exposing of the silicon nitride light waveguide (302) to a charge carrier exciting condition.

## Patentansprüche

1. Verfahren zur Herstellung einer photonischen Schaltung, die einen Siliziumnitrid-Lichtwellenleiter enthält; wobei das genannte Verfahren umfasst:
Aufbringen (102) von Siliziumnitrid auf ein Substrat zum Bilden einer Struktur, umfassend einen Siliziumnitrid-Lichtwellenleiter (302) auf ein Substrat;
Verarbeiten (104) der Struktur zum Bilden der photonischen Schaltung;
wobei das Verarbeiten (104) der Struktur umfasst, dass die Struktur der elektromagnetischen Strahlung ausgesetzt wird, die eine ausreichend große Energie aufweist, um Elektronen zu einem Leitungsband in dem Siliziumnitrid-Lichtwellenleiter (302) zu erregen;
wobei das Verfahren weiterhin das Aussetzen (106) des Siliziumnitrid-Lichtwellenleiters (302) eines einen Ladungsträger erregenden Zustandes zum Erregen von Elektronen von Ladungsfallen in dem Siliziumnitrid-Lichtwellenleiter (302) zu einem Leitungsband und Elektronendefektstellen von Ladungsfallen in dem Siliziumnitrid-Lichtwellenleiter (302) zu einem Valenzband für Ausdünnungs-Ladungsfallen derart umfasst, dass der Verbreitungsverlust von Licht durch den Siliziumnitrid-Lichtwellenleiter (302) verringert wird,
wobei das Aussetzen (106) des Siliziumnitrid-Lichtwellenleiters (302) des den Ladungsträger erregenden Zustandes das Beleuchten der Struktur mit Licht umfasst, das eine größere Energie aufweist als eine Energiedifferenz zwischen einem Ladungsfallen-Energieniveau und einem Leitungsband-Energieniveau oder einem Valenzband-Energieniveau, wobei das Licht eine kleinere Energie aufweist als eine Material-Bandlücke in dem Siliziumnitrid-Lichtwellenleiter (302); oder
wobei das Aussetzen (106) des Siliziumlicht-Wellenleiters (302) des den Ladungsträger erregenden Zustandes das Übertragen von Licht durch den Lichtwellenleiter (302) umfasst, wobei das Licht eine größere Energie aufweist als eine Energiedifferenz zwischen einem Ladungsfallen-Energieniveau und einem Leitungsband-Energieniveau oder einem Valenzband-Energieniveau, wobei das Licht eine kleinere Energie aufweist als eine Material-Bandlücke in dem Siliziumnitrid-Lichtwellenleiter (302); oder
wobei das Aussetzen (106) des Siliziumnitrid-Wellenleiters (302) des den Ladungsträger erregenden Zustandes das Aussetzen der Struktur einer Temperatur in einem Bereich von 150-400 °C umfasst.

2. Verfahren nach Anspruch 1, wobei das Verarbeiten (104) der Struktur umfasst, dass die Struktur ultraviolettem Licht ausgesetzt wird.

3. Verfahren nach Anspruch 1 oder 2, wobei das Verarbeiten (104) der Struktur das Strukturieren des Siliziumnitrid-Lichtwellenleiters (302) auf dem Substrat umfasst, das einen Lithographieschritt enthält, der die Struktur ultraviolettem Licht aussetzt.

4. Verfahren nach irgendeinem der voranstehenden Ansprüche, wobei das Verarbeiten (104) der Struktur das Reinigen einer Oberfläche der Struktur unter Einschluss wenigstens eines aus einem UV-Ozonreinigungsschritt und einem Plasma-Reinigungsschritt, unter Einschluss des Aussetzens der Struktur von ultraviolettem Licht umfasst.

5. Verfahren nach irgendeinem der voranstehenden Ansprüche, wobei die Struktur wenigstens einen Eingangskoppler umfasst, der in einer gemeinsamen Ebene mit dem Siliziumnitrid-Lichtwellenleiter (302) angeordnet ist, wobei der Eingangskoppler zum Koppeln von Licht in den Siliziumnitrid-Lichtwellenleiter (302) ausgestaltet ist.

6. Verfahren nach irgendeinem der voranstehenden Ansprüche, wobei die Struktur eine Oxidschicht (306) auf dem Siliziumnitrid-Lichtwellenleiter (302) zum Bilden eines mit Sauerstoff ummantelten Wellenleiters (302a) umfasst.

7. Verfahren nach irgendeinem der voranstehenden Ansprüche, wobei das Aufbringen (102) von Siliziumnitrid eine plasmaverstärkte chemische Dampfaufbringung einer Siliziumnitrid-Schicht umfasst.

8. Verfahren nach irgendeinem der voranstehenden Ansprüche, weiterhin umfassend das Anwenden einer biologischen Beschichtung auf dem Siliziumnitrid-Lichtwellenleiter (302).

9. Verfahren nach Anspruch 8, wobei das Anwenden der biologischen Beschichtung nach dem Aussetzen des Siliziumnitrid-Lichtwellenleiters (302) einem den Ladungsträger erregenden Zustand durchgeführt wird.

## Revendications

1. Procédé de fabrication d'un circuit photonique comprenant un guide d'onde lumineuse au nitrure de silicium, ledit procédé comprenant :
le dépôt (102) de nitrure de silicium sur un substrat pour former une structure comprenant un guide d'onde lumineuse au nitrure de silicium (302) sur un substrat ;
le traitement (104) de la structure pour former le circuit photonique ;
dans lequel le traitement (104) de la structure comprend l'exposition de la structure à une radiation électromagnétique ayant suffisamment d'énergie pour exciter des électrons jusqu'à une bande de conduction dans le guide d'onde lumineuse au nitrure de silicium (302) ;
le procédé comprenant en outre l'exposition (106) du guide d'onde lumineuse au nitrure de silicium (302) à une condition d'excitation de porteur de charge pour exciter des électrons de pièges de charge dans le guide d'onde lumineuse au nitrure de silicium (302) jusqu'à une bande de conduction, et des trous d'électrons de pièges de charge dans le guide d'onde lumineuse au nitrure de silicium (302) jusqu'à une bande de valence pour dépeupler les pièges de charge, de manière à réduire la perte de propagation lumineuse à travers le guide d'onde lumineuse au nitrure de silicium (302)
dans lequel l'exposition (106) du guide d'onde lumineuse au nitrure de silicium (302) à la condition d'excitation de porteur de charge comprend l'illumination de la structure avec de la lumière ayant une énergie supérieure à la différence d'énergie entre un niveau d'énergie de piège de charge et un niveau d'énergie de bande de conduction ou de bande de valence, la lumière ayant une énergie inférieure à celle d'une bande interdite matérielle dans le guide d'onde lumineuse au nitrure de silicium (302) ; ou
dans lequel l'exposition (106) du guide d'onde lumineuse au nitrure de silicium (302) à une condition d'excitation de porteur de charge comprend la transmission de lumière à travers le guide d'onde lumineuse (302), dans lequel la lumière a une énergie supérieure à la différence d'énergie entre un niveau d'énergie de piège de charge et un niveau d'énergie de bande de conduction ou de bande de valence, la lumière ayant une énergie inférieure à celle d'une bande interdite matérielle dans le guide d'onde lumineuse au nitrure de silicium (302) ; ou
dans lequel l'exposition (106) du guide d'onde lumineuse au nitrure de silicium (302) à une condition d'excitation de porteur de charge comprend l'exposition de la structure à une température comprise dans une plage de 150 à 400 °C.

2. Procédé selon la revendication 1, dans lequel le traitement (104) de la structure comprend l'exposition de la structure à de la lumière ultraviolette.

3. Procédé selon la revendication 1 ou 2, dans lequel le traitement (104) de la structure comprend la création de motifs du guide d'onde lumineuse au nitrure de silicium (302) sur le substrat, incluant une étape lithographique d'exposition de la structure à de la lumière ultraviolette.

4. Procédé selon l'une quelconque des revendications précédentes, dans lequel le traitement (104) de la structure comprend le nettoyage d'une surface de la structure, incluant au moins une étape parmi une étape de nettoyage UV ozone et une étape de nettoyage au plasma, comprenant l'exposition de la structure à de la lumière ultraviolette.

5. Procédé selon l'une quelconque des revendications précédentes, dans lequel la structure comprend au moins un coupleur d'entrée agencé dans un plan commun avec le guide d'onde lumineuse au nitrure de silicium (302), dans lequel le coupleur d'entrée est configuré pour coupler la lumière dans le guide d'onde lumineuse au nitrure de silicium (302).

6. Procédé selon l'une quelconque des revendications précédentes, dans lequel la structure comprend une couche d'oxyde (306) sur le guide d'onde lumineuse au nitrure de silicium (302) pour former un guide d'onde revêtu d'oxyde (302a).

7. Procédé selon l'une quelconque des revendications précédentes, dans lequel le dépôt (102) de nitrure de silicium comprend un dépôt chimique en phase vapeur assisté par plasma d'une couche de nitrure de silicium.

8. Procédé selon l'une quelconque des revendications précédentes, comprenant en outre l'application d'un revêtement biologique sur le guide d'onde lumineuse au nitrure de silicium (302).

9. Procédé selon la revendication 8, dans lequel l'application du revêtement biologique est mise en œuvre après l'exposition du guide d'onde lumineuse au nitrure de silicium (302) à une condition d'excitation de porteur de charge.
